## Europäisches Patentamt
## European Patent Office
## Office européen des brevets

(19)

(11) Veröffentlichungsnummer: **0 027 517**
**B1**

(12) **EUROPÄISCHE PATENTSCHRIFT**

(45) Veröffentlichungstag der Patentschrift:
**15.02.84**

(51) Int. Cl.³: **H 01 J 37/285,** G 01 B 7/34,
H 01 L 41/08

(21) Anmeldenummer: **80104966.9**

(22) Anmeldetag: **21.08.80**

(54) **Gerät zur rasterartigen Oberflächenuntersuchung unter Ausnutzung des Vakuum-Tunneleffekts bei kryogenischen Temperaturen.**

(30) Priorität: **20.09.79 CH 8486/79**

(43) Veröffentlichungstag der Anmeldung:
**29.04.81 Patentblatt 81/17**

(45) Bekanntmachung des Hinweises auf die Patenterteilung:
**15.02.84 Patentblatt 84/7**

(84) Benannte Vertragsstaaten:
**DE FR GB**

(56) Entgegenhaltungen:
**US - A - 3 341 704**
**US - A - 3 486 020**

**Ibm technical disclosure bulletin vol. 22, Nr. 7, Dezember 1979 New York, US G. BINNIG et al. "Piezo drive with coarse and fine adjustment" Seiten 2897-2898**
**Rev. Sci. Instrum., Vol. 47, No. 10 (1976), Seiten 1303-1304**

(73) Patentinhaber: **International Business Machines Corporation, Old Orchard Road, Armonk, N.Y. 10504 (US)**

(72) Erfinder: **Binnig, Gerd, Reidholzstrasse 41, CH-8805 Richterswil/ZH (CH)**
Erfinder: **Rohrer, Heinrich, Bachtelstrasse 27, 8805 Richterswil/ZH (CH)**

(74) Vertreter: **Schröder, Otto H., Dr.-Ing., c/o International Business Machines Corporation Zurich Patent Operations Säumerstrasse 4, CH-8803 Rüschlikon/ZH (CH)**

## Gerät zur rasterartigen Oberflächenuntersuchung unter Ausnutzung des Vakuum-Tunneleffekts bei kryogenischen Temperaturen

Die Erfindung betrifft ein Oberflächenuntersuchungsgerät höchster Auflösung, das den Vakuum-Tunneleffekt ausnutzt, mit einer Ultra-Hochvakuumkammer, die auf tiefe Temperaturen in der Nähe des absoluten Nullpunktes abgekühlt werden kann, in welcher Kammer eine leitende Probe als Basis-Elektrode vorgesehen ist, die mit einer feinen leitenden Spitze als Abtastelektrode zusammenarbeitet, die in einer Distanz über der Basis-Elektrode gehalten wird, bei der Tunnelströme fliessen können.

Zu Methoden für die Untersuchung von Oberflächen gehört seit alters her die visuelle Inspektion oder das Betrachten der Probe mit dem menschlichen Auge. Dem optischen Auflösungsvermögen sind jedoch natürliche Grenzen gesetzt. Mit bekannten optischen Instrumenten sucht man, das Auflösungsvermögen für das Auge des Beobachters zu verbessern. Jedoch auch mit den besten lichtoptischen Geräten kommt man bald an Grenzen, die nicht überschritten werden können, weil sie durch die Natur der elektromagnetischen Lichtstrahlung gegeben sind.

Das Auflösungsvermögen kann durch Geräte verbessert werden, die mit Strahlung kürzerer Wellenlänge arbeiten wie beispielsweise das Elektronenmikroskop. Der apparative Aufwand wird jedoch grösser, weil man jetzt im Vakuum arbeitet und das Ergebnis der Untersuchung auf einem Bildschirm oder auf einer Photoschicht sichtbar machen muss. Die laterale Auflösung wird im Vergleich zu Lichtmikroskopen wesentlich verbessert. Die vertikale Auflösung findet jedoch auch bald ihre Grenze.

Oberflächenuntersuchungsgeräte arbeiten mit elektromagnetischer Strahlung oder mit einer Korpuskularstrahlung, die mit der Probenoberfläche in Wechselwirkung tritt. Bei Geräten, die noch atomare oder molekulare Bereiche aufzulösen gestatten, kann man eigentlich nicht mehr von einer Abbildung im Sinne eines visuellen Betrachtens sprechen. Dennoch geben solche Geräte genügend Information, die Rückschlüsse auf die Struktur und die Zusammensetzung der Probenoberfläche ermöglicht. Beispielsweise kann man mit besonderen Apparaten die selektive Streuung von Elektronen niedriger Energie an einer Probenoberfläche beobachten. Oder man macht Massenspektroskopie mit sekundären Ionen.

Bei einer Abbildung der Oberfläche mit gleichenergetischer Strahlung spricht man von Mikroskopie. Im Falle einer Untersuchung mit Strahlung unterschiedlicher Spannung oder Frequenz, d.h. mit variierender Energie, spricht man im allgemeinen von Spektroskopie. Dennoch nennt man die Geräte meist Mikroskope, auch wenn sie zusätzlich spektroskopische Untersuchungen ermöglichen.

Allen diesen bekannten Geräten ist gemeinsam, dass die Oberflächenuntersuchungen in einem guten Vakuum von beispielsweise $1{,}3 \cdot 10^{-8}$ pa ($10^{-10}$ Torr) erfolgen. Die Temperaturen sind möglichst niedrige kryogenische Temperaturen. Die verwendeten Partikeln sind freie Teilchen, die sich im Hochvakuum unter dem Einfluss angelegter Felder frei bewegen. Sie müssen also durch irgendeine Kathode oder eine Ionenquelle vorher freigesetzt worden sein.

Unterliegen in einem atomaren System oder in einem Festkörper geladene Teilchen einer Wechselwirkung, bei der eine abstossende Komponente grosser Reichweite und eine anziehende Komponente kleiner Reichweite beteiligt sind, dann bildet das Potential der resultierenden Kraft einen Wall oder eine Barriere. Nach klassischen Vorstellungen kann eine solche Barriere nur überschritten werden, wenn die Energie des Teilchens genügend gross ist, diese Schranke zu überwinden. Es gibt aber bei atomaren Teilchen, die in einem solchen Potential gebunden sind, auch eine endliche Anzahl von Teilchen, die in der Lage sind, den Potentialwall dennoch zu überwinden, auch wenn ihre Energie dazu eigentlich nicht ausreicht. Nach einer bildhaften Vorstellung unterschreiten sie den Potentialwall sozusagen in einem Tunnel. Der danach so benannte Tunneleffekt ist nur wellenmechanisch erklärbar. Atomare Teilchen haben insofern eine Doppelnatur, als man nur einen Teil ihrer Eigenschaften aus dem Partikelbild und einen anderen Teil ihrer Eigenschaften nur aus dem Wellenbild deuten kann. Der Tunneleffekt ist eine Welleneigenschaft, die man etwa mit einem Anpassungsproblem fortschreitender Wellen an Grenzflächen von verschiedenen Medien vergleichen kann.

Nach dem Tunneleffekt besteht eine berechenbare Wahrscheinlichkeit dafür, dass eine endliche Anzahl von in einem Potential gebundenen Elektronen die Tunnelbarriere auch bei geringen Spannungsunterschieden überwinden kann. Eine Tunnelbarriere kann beispielsweise durch eine dünne Schicht eines Festkörpers gebildet sein. Aber auch das Hochvakuum bildet in einer Schichtdicke von wenigen bis einigen hundert Angströmeinheiten eine Tunnelbarriere. Diese Strecke vermögen auch gebundene Elektronen zu durchtunneln. Bei Vakuum-Tunnelexperimenten, wie beispielsweise von W.A. Thompson und S.F. Hanrahan im Artikel «Thermal drive apparatus for direct vacuum tunneling experiments» (Rev. Sci. Instrum., Vol. 47, Nr. 10, Okt. 76, Seiten 1303/1304) beschrieben, fliesst ein sehr schwacher Tunnelstrom von einer leitenden feinen Spitze zu einer flachen Gegenelektrode, oberhalb derer die Spitze in entsprechendem geringen Abstand schwebt. Bis jetzt bekannte Experimente waren wegen der erheblichen technischen Schwierigkeiten sehr aufwendig an Apparaturen und Zeit. Sie brauchten viele Stunden, um nur einen Messpunkt zu gewinnen. Eine Messreihe benötigte viele Tage.

Man hat Experimente mit Feldelektronenemission gemacht, wobei eine feine Spitze als Elektronenquelle oder als sogenannte kalte Kathode wirkte. Hier wird der Tunneleffekt nur dazu verwendet, Elektronen aus dem Metall der Spitze in das Vakuum freizusetzen. Unter dem Einfluss starker elektrischer Felder erfolgt eine Art Abbildung der emittierenden Spitze durch Beschleunigung der frei gewordenen Elektronen in Richtung auf einen Schirm oder eine Photoschicht. Die von den Elektronen im Vakuum durchlaufenen Strecken sind wesentlich länger als der kurze Bereich, in dem ein Vakuum-Tunneleffekt der gebundenen Elektronen möglich ist.

Die Aufgabe der Erfindung besteht darin, ein neues Oberflächenuntersuchungsgerät höchster Auflösung anzugeben, das den Vakuum-Tunneleffekt ausnutzt. Es arbeitet daher mit durch ein Potential gebundenen Elektronen. Die Information über die untersuchte Probenoberfläche soll in möglichst kurzer Zeit verfügbar sein.

Die Lösung dieser Aufgabe besteht in der Schaffung eines Raster-Tunnelmikroskops, wie es im Patentanspruch 1 gekennzeichnet ist.

Um ein solches Gerät zu realisieren, müssen erhebliche technische Schwierigkeiten überwunden werden. Man muss in einem Ultra-Hochvakuum arbeiten, das besser als $1,3 \cdot 10^{-8}$ pa ($10^{-10}$ Torr) ist. Weiter sollte die Temperatur möglichst dem absoluten Nullpunkt angenähert sein. Das bedeutet geringere Temperaturen als die Heliumtemperatur von $4,2$ K. Die Arbeitstemperatur sollte im Bereich kleiner als 1 K liegen und zweckmässig etwa 0,3 K betragen. Unter diesen extremen Bedingungen sollen die Verstellvorrichtungen mit Arbeitshüben in der Grössenordnung von Zehntel Nanometer noch funktionsfähig sein und reproduzierbare, definierte Positionen einnehmen können. Besondere Schwierigkeiten bereitet die Vorrichtung für die Höhenverstellung. Denn einmal muss sie relativ grob Wege in der Grössenordnung von Millimetern zu Beginn einer Untersuchung zurücklegen, wenn die Apparatur mit einer zu untersuchenden Probe beschickt wird. Während der eigentlichen Untersuchung muss sie jedoch sehr fein mit einer Genauigkeit in der Grössenordnung von Bruchteilen eines Zehntel Nanometers arbeiten können. Besonderes Augenmerk muss bei alledem auf absolute Schwingungsfreiheit gelegt werden. Thermische Fluktuationen, die in der Grössenordnung von Zehntel Nanometer wären und damit auch in der Grössenordnung der Arbeitsbereiche des Gerätes liegen, werden bereits durch die extreme Abkühlung unterbunden. Aber jeder noch so kleine Schallimpuls würde als Körperschall störend in Erscheinung treten. Deshalb wird grosser Wert auf eine optimale Aufhängung oder Lagerung der wesentlichen Teile des Gerätes gelegt.

Das Prinzip des erfindungsgemässen Oberflächenuntersuchungsgerätes wird im folgenden anhand von Ausführungsbeispielen mit Hilfe der Zeichnungen näher erläutert.

Fig. 1 zeigt schematisch als Blockschaltbild die wesentlichen Teile des erfindungsgemässen Oberflächenuntersuchungsgerätes.

Fig. 2 dient zur Erläuterung des Tunneleffektes durch eine Barriere zwischen zwei Metallen.

Fig. 3 zeigt graphisch die starke Abhängigkeit des Tunnelstromes von den Abmessungen der Barriere am Beispiel des Vakuum-Tunneleffektes.

Fig. 4 dient zur Erläuterung des Prinzips der Abtastung durch Regelung der Spitzenhöhe über der Probenoberfläche während des Abtastens in einer lateralen Dimension.

Fig. 5 dient zur Erläuterung des Prinzips der wiederholten lateralen Abtastung der Probenoberfläche in parallelen Rasterlinien.

Fig. 6 zeigt schematisch eine dreidimensionale Darstellungsmöglichkeit der Untersuchungsergebnisse in Form der Spitzenpositionswerte bzw. der ihnen proportionalen Verstellspannungen der piezoelektrischen Verstellvorrichtungen.

Fig. 7 dient zur Erläuterung des Prinzips einer zusätzlichen Höhenabstandsvariation oder Modulation der Abtastspitze während des Abtastens, um zusätzliche Information wie über eine mögliche Änderung der Austrittsarbeit der Probenoberfläche zu gewinnen.

Fig. 8 zeigt schematisch eine Darstellungsmöglichkeit für die nach dem anhand der Fig. 7 erläuterten Prinzip gewonnene zusätzliche Information.

Fig. 9 zeigt eine vergleichende Übersicht über die Grenzen des Auflösungsvermögens des menschlichen Auges, einiger Mikroskope und des erfindungsgemässen Raster-Tunnelmikroskops.

Fig. 10 zeigt eine mögliche Anordnung der piezoelektrischen Verstellvorrichtungen in lateraler Richtung.

Fig. 11 zeigt die sowohl für eine Grobeinstellung als auch für eine Feineinstellung eingerichtete piezoelektrische Höhen-Verstellvorrichtung sowie schematisch Treibsignalzüge, die für die Grobeinstellung gebraucht werden.

Fig. 12 zeigt perspektivisch einen Abschnitt des trogartigen Führungsstückes für die piezoelektrische Höhen-Verstellvorrichtung nach der Fig. 11.

Fig. 13 zeigt in einer Schnittansicht die Anordnung der inneren Teile der Apparatur. Sie dient auch zur Erläuterung von Massnahmen für ihre schwingungsfreie Lagerung.

Fig. 14 zeigt eine Übersicht über die Hochvakuumkammer und die inneren Teile der Apparatur.

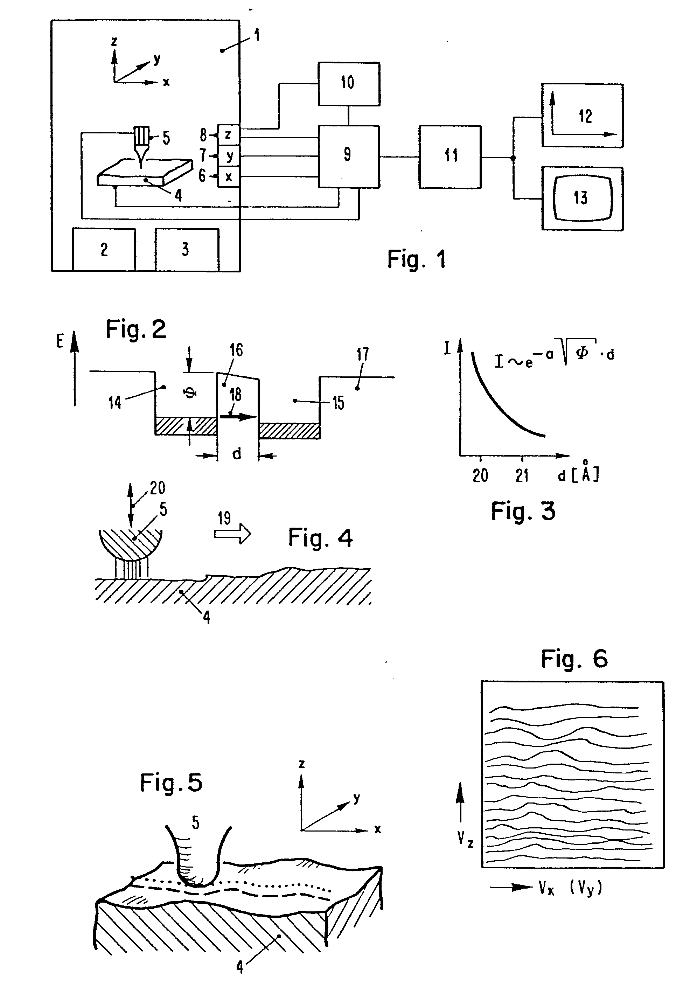

In der Fig. 1 sind die wesentlichen Teile des neuen Oberflächenuntersuchungsgerätes als Blockschema dargestellt. Eine Ultra-Hochvakuumkammer 1 enthält Mittel zum Erzeugen eines Hochvakuums, das besser als $1,3 \cdot 10^{-8}$ pa ($10^{-10}$ Torr) ist. Diese Mittel sind allgemein als Vakuumpumpe 2 dargestellt, unabhängig davon, ob in der Praxis ein Satz von mehreren Pumpen oder anderen Einrichtungen vorhanden ist. Eine Kältequelle 3 dient zum Kühlen der Ultra-Hochvakuumkammer 1. Als Kältequelle kann jede dazu geeignete Einrichtung dienen. Um zu möglichst tiefen Temperaturen zu gelangen, verwendet man flüssiges Helium oder einen Mischkryostaten, der mit beiden Heliumisotopen $^3$He und $^4$He arbeitet. Zur Vorkühlung dient ein äusserer Mantel mit flüssigem Stickstoff. Eine Probe 4 wirkt als Basis-Elektrode, über der in geringem Abstand eine Spitze 5 als Abtastelektrode schwebt. Diese Elektroden sind schematisch in übertriebener Grösse gezeichnet. Sie können relativ zueinander in drei Dimensionen verstellt werden, wie symbolisch durch drei sich rechtwinklig schneidende Achsen dargestellt ist, die mit x, y und z bezeichnet sind. Weiterhin sind drei piezoelektrische Verstellvorrichtungen 6, 7 und 8 für die Elektroden vorgesehen. Die Verstellvorrichtungen 6 und 7 mögen in den lateralen Dimensionen x und y wirken. Sie können beispielsweise an der Probe 4 angreifen und diese relativ zur Spitze 5 verstellen. Die Probe 4 kann aber auch ortsfest angeordnet sein und die lateralen Verstellvorrichtungen 6 und 7 wirken auf die Spitze 5, die ihrerseits mittels der Verstellvorrichtung 8 in der Höhen-Dimension z verstellbar ist.

Ausserhalb der Ultra-Hochvakuumkammer 1 befinden sich alle Einrichtungen für die Versorgung der Apparatur mit Energie und mit Kühlmitteln, sowie die Einrichtungen für die Steuerung und Regelung der Apparatur und die Einrichtungen für die Auswertung und Anzeige der Untersuchungsergebnisse. Von diesen Einrichtungen sind in der Fig. 1 nur einige wesentliche schematisch angedeutet. Messeinrichtungen 9 als Teil der elektronischen Steuereinrichtungen sind sowohl mit den Elektroden, d.h. mit der Probe 4 und der Spitze 5 verbunden, als auch mit den piezoelektrischen Verstellvorrichtungen 6, 7 und 8 aller drei Dimensionen. Eine Regeleinrichtung 10 ist mit den Messeinrichtungen 9 verbunden und wirkt auf die Höhen-Verstellvorrichtung 8 ein. Die Messeinrichtungen 9 sind mit Auswerteeinrichtungen 11 verbunden, an die beispielsweise ein Zeichengerät 12 und ein Bildschirmgerät 13 angeschlossen sind.

Der heiklen Natur des Vakuum-Tunneleffektes gemäss sind die mechanischen Abmessungen der Elektroden Probe und Spitze, sowie ihre möglichen Verstellwege ausserordentlich klein. Die elektronischen Einrichtungen für die Steuerung und Regelung müssen sehr präzis arbeiten können und die Messeinrichtungen müssen ausserordentlich empfindlich sein. Die von gebundenen Elektronen durch Tunnels im Vakuum überwindbare Barriere liegt in der Grössenordnung von $1\,nm\,(10\,Å)$ bis $10\,nm\,(100\,Å)$. Die Spitze muss deshalb über der Probe in einem Abstand dieser Grössenordnung schwebend verfahren werden. Sie darf dabei jedoch nicht anstossen und auf diese Weise leitenden Kontakt machen. Auch darf sie sich nicht so weit von der Oberfläche der untersuchenden Probe entfernen, dass keine reinen Tunnelströme mehr möglich sind. Die Stromdichte der Tunnelströme liegt in der Grössenordnung von $100\,A\,cm^{-2}$. Wegen der ausserordentlich kleinen Abmessungen liegen die in der Realität fliessenden Tunnelströme bei etwa $10^{-10}\,A$. Der Krümmungsradius der scharfen Spitze ist in diesem Falle in der Grössenordnung von $100\,nm\,(1000\,Å)$. Es lässt sich rechnerisch zeigen, dass räumlich etwa die Hälfte des Tunnelstromes durch einen zentralen Schlauch zwischen Spitze und Probe mit einem Durchmesser von etwa $10\,nm\,(100\,Å)$ fliesst. Nach aussen nimmt die Stromdichte schnell ab. Das Tunnelmikroskop hat also eine Art «Brennfleck» mit einem Radius von $5\,nm\,(50\,Å)$. In lateraler Richtung sollte deshalb die Bewegung der Spitze über der Probenoberfläche in Schritten erfolgen, die nicht grösser als $5\,nm\,(50\,Å)$ sind. Die elementaren Schritte dürfen kleiner sein, weil auch sich räumlich überlappende Messungen noch auswertbare Information liefern können.

Wesentlich höhere Genauigkeit in reproduzierbarer Form sollte jedoch die Höhen-Verstellvorrichtung haben. Mit der z-Dimension variiert der Tunnelstrom nämlich sehr stark. Die Tunnelwahrscheinlichkeit und damit der Tunnelstrom hängt exponentiell von der Distanz der Elektroden ab. Deshalb sollte die Genauigkeit mindestens $0,01\,nm\,(0,1\,Å)$ betragen, um noch eine vertikale Auflösung in der Grössenordnung von $0,1\,nm\,(1\,Å)$ zu gewährleisten.

Die Verstellvorrichtungen sollen nicht nur in allen Dimensionen kleine Verstellwege einzustellen gestatten, sondern ihre Einstellwerte sollen auch eindeutig und reproduzierbar sein. Zuverlässig sollen sie auch im Ultra-Hochvakuum und bei Temperaturen nahe dem absoluten Nullpunkt arbeiten können. Verstellvorrichtungen, die diese Bedingungen erfüllen, sind beispielsweise piezoelektrische Verstellvorrichtungen. Aus den Einstellwerten ist die genaue Position der Spitze 5 in drei Koordinaten bekannt.

Wie bei physikalischen Experimenten kann man den Tunnelstrom bei einer bestimmten angelegten Spannung messen, woraus man den Tunnelwiderstand der Vakuum-Tunnelbarriere für eine bestimmte Elektrodenkombination in Abhängigkeit von den räumlichen Koordinaten bestimmen kann. Das neue Oberflächenuntersuchungsgerät soll jedoch nicht nur Daten über einzelne Messpunkte liefern, sondern es soll in kurzer Zeit Aufschluss über ein ganzes Gebiet einer untersuchten Probenoberfläche geben. Zu diesem Zweck arbeitet es nach dem Prinzip eines Rastermikroskops. Die Probenoberfläche wird nacheinander in Rasterlinien untersucht und das Gesamtbild wird aus den Abtastzeilen des Rasters zusammengesetzt. Bei der Abtastung arbeitet die Verstellvorrichtung einer ersten lateralen Dimension für eine Rasterlinie, während die Verstellvorrichtung der dazu senkrechten anderen lateralen Dimension als Parameter festgehalten wird. Nach deren seitlicher Verstellung um einen Zeilenabstand wird dann die nächste Zeile mittels der ersten Verstellvorrichtung abgetastet und so weiter.

Eine Gefahr beim Abtasten mittels der über einer Probenoberfläche schwebenden Spitze besteht in der Möglichkeit der unbeabsichtigten Berührung, weil Oberflächenrauhigkeiten durchaus in der Grössenordnung der Vakuum-Tunnelbarriere, also der vertikalen Distanz der Spitze über der Probe liegen können. Solche unfreiwilligen Kontakte sollten vermieden werden. Das neue Oberflächenuntersuchungsgerät vermeidet automatisch durch seinen Betrieb als Raster-Tunnelmikroskop diese Gefahr. Der Abtastvorgang ist in seinen lateralen Dimensionen vorgegeben. Einzig die vertikale Distanz der Spitze ist variierbar. Hier ist nun die Einrichtung so getroffen, dass durch das dem neuen Raster-Tunnelmikroskop eigentümliche Messverfahren bzw. das Regelverfahren immer ein Abstand der Spitze von der Probenoberfläche automatisch eingehalten wird. Durch laufende Messungen sind die elektrischen Parameter wie die Werte des Tunnelstromes, der anliegenden Spannung und damit des Tunnelwiderstandes jederzeit bekannt oder leicht zu ermitteln. Man kann das Betriebsverfahren so führen, dass beispielsweise die an den Elektroden anliegende Spannung konstant gehalten wird und durch Feineinstellung der Höhendistanz der Spitze über der Probe der Tunnelstrom jederzeit auf einen Sollwert geregelt wird. Mit komplizierten Regeleinrichtungen kann die Apparatur auch direkt auf einen konstanten Tunnelwiderstand geregelt werden. Ein anderer, dem Tunnelwiderstand proportionaler elektrischer Parameter als Sollwert für die Regelung kann u.U. auch die anliegende Spannung sein, wenn der Tunnelstrom konstant gehalten wird und wenn durch Feineinstellung der vertikalen Distanz die Apparatur auf die Sollspannung geregelt wird. In jedem Falle wird durch die Messung der elektrischen Parameter und durch die Feineinstellung der Höhen-Verstellvorrichtung in der z-Dimension mittels einer geschlossenen Regelschleife während der Abtastbewegung in einer lateralen Dimension auf einen dem Tunnelwiderstand proportionalen elektrischen Parameter geregelt.

Das Abtastraster ist im allgemeinen ein Zeilenraster, wobei die Fläche in geraden, parallelen Zeilen einer ersten lateralen Dimension (x) nacheinander abgetastet wird. Die zweite laterale Dimension (y) ist der Parameter der Abtastung. Die unabhängige Variable ist die nach elektrischen Messwerten proportional dem Tunnelwiderstand nachgeregelte Höhendistanz, die dritte Dimension (z). Da die Verstellung einer piezoelektrischen Verstellvorrichtung proportional der Piezospannung bzw. dem Verstellstrom ist, ergeben die Stellströme der drei piezoelektrischen Verstellvorrichtungen Werte, die der Position der Spitze in jeder Dimension äquivalent sind. Die Koordinaten sind im allgemeinen kartesische Koordinaten mit drei aufeinander senkrecht stehenden Achsen. Zumindest sollen Komponenten der Abtastbewegung in drei Koordinaten verlaufen. Es sind daher auch gekrümmte Abtastzeilen in den lateralen Dimensionen zulässig, wenn sie nur in reproduzierbarer Weise gewonnen werden.

Die Auswertung muss in einer dreidimensionalen Darstellung erfolgen. Die lateralen Dimensionen sind leicht in einem Achsenkreuz eines Zeichengerätes 12 oder auf einem Bildschirm eines Bildschirmgerätes 13 aufzuzeichnen. Für die dritte Dimension muss man eine geeignete Darstellung wählen. Man kann die Messwerte als Kurvenschar x (z) mit dem Parameter y darstellen. Man kann aber auch die z-Werte als Helligkeitsstufen an den Punkten x, y erscheinen lassen. Bei zeichnerischer Darstellung können es beispielsweise verschieden grossflächige Punkte oder andere Symbole sein. Bei Bildschirmdarstellung kann die Helligkeit der Bildröhre entsprechend den Werten der dritten Dimension gesteuert sein.

Die Spitze wird über die Oberfläche der Probe in einem vertikalen Abstand so geführt, dass während der Abtastbewegung der Tunnelwiderstand der Vakuum-Tunnelbarriere auf einen konstanten Wert geregelt wird. Unter der Voraussetzung, dass die Austrittsarbeit des Probenmaterials örtlich konstant ist, bleibt in diesem Falle auch die Stärke der Vakuum-Tunnelbarriere konstant bei einem definierten Wert. Für die Abtastbewegung bedeutet das, dass die Spitze in einem definierten Abstand allen Unebenheiten und Rauhigkeiten der Probenoberfläche folgt. Der Stellstrom der Höhen-Verstellvorrichtung ergibt so ein getreues Abbild der Oberflächenform. Das ausgewertete Bild des Raster-Tunnelmikroskops ergibt bei konstanter Austrittsarbeit der Probe ein ausserordentlich stark vergrössertes Bild der Probenoberfläche.

Ist durch Einschlüsse im Probenmaterial, durch Oxydschichten, durch Adsorbanden oder durch andere Materialfehler die Austrittsarbeit der Probe nicht mehr örtlich konstant, so kann das neue Oberflächenuntersuchungsgerät auch in diesem Falle wertvolle Information liefern. Man kann das Messverfahren auf verschiedene Weise verfeinern. Eine überlagerte mechanische Höhenmodulation der Spitze und ein geeignetes frequenz- und phasenabhängiges Messverfahren ermöglicht, Änderungen des Tunnelstroms mit der z-Dimension zu erfassen und Rückschlüsse auf Änderungen der Austrittsarbeit der Probe zu ziehen.

Leitungselektronen können ein Metall im allgemeinen nur verlassen, wenn sie die Austrittsarbeit $\Phi$ von einigen Elektronenvolt, beispielsweise etwa 5 eV leisten. In einem Energiediagramm nach der Fig. 2 sind die Elektronen eines ersten Metalls in einem ersten Potentialtopf 14 gebunden und nehmen dort die niedrigsten Energiezustände ein, wie durch Schraffur angedeutet ist. Ein zweites Metall ist durch einen zweiten Potentialtopf 15 charakterisiert, der durch eine Potentialbarriere 16 vom ersten Potentialtopf 14 getrennt ist. Diese Potentialbarriere 16 kann im allgemeinen von den Elektronen nicht überwunden werden, so dass die Elektronen nicht ohne weiteres vom ersten Metall in das zweite Metall gelangen. Sollen Elektronen ein Metall beispielsweise in ein Vakuum verlassen können, muss zuerst ihre Energie E um den Betrag der Austrittsarbeit $\Phi$ über die obere Begrenzung der gebundenen Energiezustände, die sogenannte Emissionskante 17 angehoben werden. Die energiereichen Elektronen werden vom Metall emittiert und können sich jetzt als freie Elektronen im Vakuum frei bewegen. Sie können jetzt auch jederzeit in das zweite Metall gelangen und dort niedrigere Energiezustände annehmen, die durch Schraffur im zweiten Potentialtopf 15 angedeutet sind. Ohne Energiezufuhr von mindestens dem Werte der Austrittsarbeit $\Phi$ können nach der klassischen Partikelvorstellung keine Elektronen vom ersten Metall in das zweite Metall gelangen. Die Potentialbarriere 16 habe eine gewisse räumliche Ausdehnung, eine Barrierendicke d. Unter bestimmten Bedingungen, die von der Austrittsarbeit $\Phi$, der Barrierendicke d und von atomaren Naturkonstanten abhängen, kann auch ein Strom gebundener Elektronen vom ersten zum zweiten Metall gelangen, die energiemässig die Potentialbarriere 16 und damit die Emissionskante 17 nicht überschreiten. Dieser sogenannte Tunnelstrom kann schon fliessen, wenn zwischen dem ersten Metall und dem zweiten Metall ein geringer Energieunterschied, eine Potentialdifferenz besteht. In der Fig. 2 erscheint der erste Potentialtopf 14 gegenüber dem zweiten Potentialtopf 15 etwas angehoben, was man durch eine zwischen beiden Metallen angelegte, geringe elektrische Spannung erreichen kann. Bereits eine Energiedifferenz von 1 meV entspricht einer thermischen Anregung von 11,6 K. Der Pfeil 18 symbolisiert den vom ersten zum zweiten Metall fliessenden Tunnelstrom. Um thermische Anregung der Leitungselektronen zu vermeiden, sollte die Temperatur sehr niedrig sein und in der Nähe des absoluten Nullpunktes liegen.

Die Tunnelwahrscheinlichkeit hängt sehr stark von der Barrierendicke ab. Die entsprechende exponentielle Abhängigkeit des Tunnelstromes I von der Barrierendicke d ist in der Fig. 3 graphisch dargestellt. In der zugehörigen Formel sind die atomaren Naturkonstanten in einer Konstanten a zusammengefasst. Im Exponenten erscheint ausserdem die Austrittsarbeit $\Phi$ unter dem Wurzelzeichen, sowie die Barrierendicke d. Man erkennt, dass bei konstanter Austrittsarbeit $\Phi$ der Tunnelstrom I nur noch von der Barrierendicke d abhängt. Das gilt auch für eine Vakuum-Tunnelbarriere. Daraus folgt, dass die Anzeige des erfindungsgemässen Raster-Tunnelmikroskops bei örtlich konstanter Austrittsarbeit $\Phi$ der Probe eine getreue Abbildung der Probenoberfläche liefert.

Die Fig. 4 zeigt schematisch und stark vergrössert die Abtastung der Oberfläche der Probe 4 durch die im Abstand der Vakuum-Tunnelbarriere darüber schwebende Spitze 5 in einer lateralen Dimension. Der Tunnelstrom fliesst durch das Vakuum zwischen den beiden Elektroden. Die Bewegungsrichtung 19 kann beispielsweise der x-Dimension entsprechen. Die vertikale Höhe der Spitze 5 über der Probenoberfläche möge für die gewählten elektrischen Parameter zum Betrieb des Raster-Tunnelmikroskops in der Grössenordnung von etwa 2 nm (20 Å) liegen. Die Unebenheiten und Rauhigkeiten der Probenoberfläche liegen im gleichen Bereich. Bereits eine Stufe einer Atomlage kann die Abtastbewegung der feinen Spitzenelektrode empfindlich behindern, wenn nicht durch die automatische Regelung dafür gesorgt wird, dass die Spitzenhöhe während der Abtastbewegung sich der Probenoberflächenform anpasst. Der Doppelpfeil 20 deutet an, dass während der Abtastbewegung in der Richtung 19 die Spitze 5 in vertikaler Richtung laufend durch Feineinstellung mittels der piezoelektrischen Verstellvorrichtung 8 entsprechend den gemessenen elektrischen Werten nachgeregelt wird. Der Verstellstrom bzw. die Piezospannung der Höhen-Verstellvorrichtung ergibt den Messwert der unabhängigen Variablen, der für die Anzeige bzw. die Darstellung der untersuchten Probenoberfläche ausgewertet wird.

Nach der Abtastung einer Rasterlinie in einer ersten lateralen Dimension (x) der Probe 4 kann man die Spitze 5 in der dazu senkrechten zweiten lateralen Dimension (y) um die Breite einer Rasterlinie verstellen. Anschliessend kann man dann eine zu der ersten Linie parallele Rasterlinie abtasten. Durch wiederholtes laterales Abtasten in parallelen Rasterlinien kann man so die ganze Probenoberfläche zeilenweise abtasten. In der perspektivischen Darstellung der Fig. 5 sind stark vergrössert und schematisch die beiden Elektroden 4 und 5 während der Abtastung einer Rasterlinie gezeigt. Eine gestrichelte Linie auf der Probenoberfläche deutet den Weg des Fusspunktes unterhalb der Spitze 5 auf der Oberfläche der Probe 4 an. Eine punktierte Linie im Abstand der Vakuum-Tunnelbarriere markiert den Weg der Spitze selbst. Das Achsensystem x, y, z bezeichnet die Koordinaten der Dimensionen. Beispielsweise erfolgt die Abtastung in der x-Richtung. Bei der wiederholten Abtastung wird jeweils um die Breite einer Rasterlinie in der y-Dimension verstellt. In der z-Richtung erfolgt die Feineinstellung der Höhen-Verstellvorrichtung aufgrund der Regelung der Apparatur auf konstanten Tunnelwiderstand. Zum Auswerten der Ergebnisse des erfindungsgemässen Raster-Tunnelmikroskops kann man als Kurvenschar die Verstellströme bzw. Piezospannungen in drei Dimensionen darstellen. Diese Werte entsprechen als äquivalente elektrische Messwerte den Positionen der feinen Spitze 5 in drei Koordinatenrichtungen. Die Fig. 6 zeigt beispielsweise die Piezospannungen Vz in Abhängigkeit von Vx als Kurvenschar mit dem Parameter (Vy). Unter der Voraussetzung örtlich konstanter Austrittsarbeit $\Phi$ des Probenmaterials bleibt die Vakuum-Tunnelbarriere bei auf einen konstanten Wert geregeltem Tunnelwiderstand ebenfalls konstant. Die Abtastspitze folgt in diesem Falle genau der Form der Oberfläche der Probe in konstantem vertikalem Abstand. Die Kurvenschar der Fig. 6 ist also ein getreues Abbild der Probenoberfläche in stark vergrössertem Massstab.

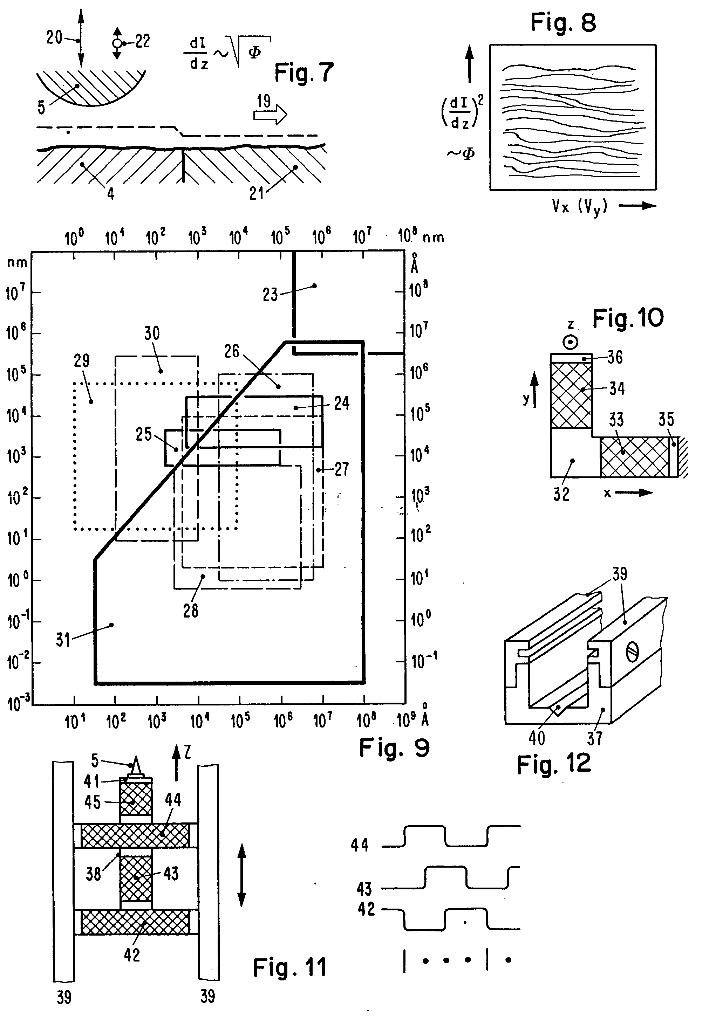

Im Falle einer örtlichen Variation der Austrittsarbeit $\Phi$ der Probe ändert sich auch bei konstantem Tunnelwiderstand die Stärke der Vakuum-Tunnelbarriere. Die Höhenkoordinatenwerte der Position der Abtastspitze sind dann nicht mehr eindeutig der Form der Probenoberfläche zugeordnet. Um während der Abtastung an jedem Messpunkt eine zusätzliche Information über eine mögliche Änderung der Austrittsarbeit der Probe gegenüber dem benachbarten Messpunkt zu erhalten, kann man das Verfahren der Messung und der Auswertung weiter verfeinern. Die Fig. 7 deutet, ähnlich wie die Fig. 4, die Abtastung der Oberfläche der Probe 4 durch die Spitze 5 in einer lateralen Dimension an. Gleiche Bezeichnungen haben die gleiche Bedeutung. Die Probe 4 ist hier mit relativ glatter Oberfläche angenommen. Sie enthält jedoch eine Inhomogenität 21, bei der sich die Austrittsarbeit $\Phi$ ändert. Beim Fortschreiten der Spitze 5 in der Bewegungsrichtung 19 ändert sich an der Inhomogenität 21 auch die Abmessung der Tunnelbarriere bei dem gleichen, durch die Regelung konstant gehaltenen Tunnelwiderstand. Die punktierte Linie, die den Ort der Abtastspitze bei der Abtastbewegung markiert, ändert das Niveau beim Überschreiten der Inhomogenität 21. Um zusätzliche Information über eine mögliche Änderung der Austrittsarbeit $\Phi$ gewinnen zu können, wird der abtastenden Spitze 5 eine zusätzliche periodische Bewegung in der Vertikalen erteilt. Mit beispielsweise 100 Hz erfolgt diese Abstandsvariation oder Modulation der Abtastspitze. In der exponentiellen Abhängigkeit des Tunnelstromes I von der Barrierendicke d (vgl. Fig. 3) steht die Austrittsarbeit $\Phi$ im Exponenten unter dem Wurzelzeichen.

Die durch die Änderung der Austrittsarbeit bedingte Änderung der Barrierendicke kann aus der Änderung des Tunnelstromes während der Abstandsvariation der Abtastspitze an einen Messpunkt erschlossen werden. Die Modulationsbreite der zusätzlichen Höhenvariation um den Mittelwert der Höhenkoordinate herum, der durch die Regelung auf konstanten Tunnelwiderstand bedingt ist, ist konstant oder zumindest bekannt. Bei der Ableitung des Tunnelstromes I nach der vertikalen Auslenkung in Richtung der z-Koordinate tritt die Wurzel aus der Austrittsarbeit als Faktor vor die Exponentialfunktion. Da in erster Näherung die übrigen Variablen an einem Messpunkt als konstant anzusehen sind, ist die Änderung des Tunnelstromes mit der Abstandsvariation dI/dz praktisch proportional der Wurzel aus der Austrittsarbeit $\sqrt{\Phi}$. Der Aufwand für die elektronische Auswertung dieser zusätzlichen Messwerte wird entsprechend grösser. Mittels eines phasen- und frequenzselektiven Verstärkers, eines sogenannten Mitziehverstärkers (lock-in amplifier), kann man neben den übrigen für die Regelung und Anzeige notwendigen Messwerten auch die durch die zusätzliche Modulation erzeugten Werte herausfiltern und getrennt auswerten. Zweckmässig benutzt man das Quadrat dieser Messwerte, das praktisch proportional der Austrittsarbeit $\Phi$ ist. In der Fig. 8 ist eine Möglichkeit der Anzeige der Ergebnisse angedeutet. Auf einem zweiten Zeichengerät oder Bildschirm stellt man die Kurvenschar der Abhängigkeit der Austrittsarbeit $\Phi$ von der Piezospannung in der x-Richtung Vx dar, mit der Piezospannung in der y-Richtung (Vy) als Parameter. Neben der durch den grossen Doppelpfeil 20 in der Fig. 7 bezeichneten Regelung der Höhe der Spitze 5 gemäss einem elektrischen Wert, der dem Tunnelwiderstand proportional ist, erfolgt um die Mittellage der Regelung die überlagerte zusätzliche Abstandsvariation der Spitze 5. In der Zeichnung ist das durch den kleinen Doppelpfeil 22 angedeutet. Die Höhen-Verstellvorrichtung muss dann entsprechend eingerichtet sein.

Das neue Raster-Tunnelmikroskop hat ein ausserordentlich gutes Auflösungsvermögen. Die vergleichende Übersicht der Fig. 9 lässt die Grenzen des Auflösungsvermögens einiger Arten von Mikroskopen im Vergleich zum menschlichen Auge erkennen. Als Abszisse ist die laterale Auflösung im Bereich von $10^8$ nm - 0,1 nm ($10^9$ Å - 1 Å) aufgetragen. Als Ordinate ist die vertikale Auflösung im Bereich von $10^8$ nm - $10^{-3}$ ($10^9$ Å - $10^{-2}$ Å) aufgetragen. Die Grenzen 23 des Auflösungsvermögens des menschlichen Auges liegen etwa im Bereich von $10^8$ - $10^5$ nm ($10^9$ Å - $10^6$ Å) bei der lateralen Auflösung und $10^8$ - $10^6$ nm ($10^9$ Å - $10^7$ Å) bei der vertikalen Auflösung. Es lassen sich grob drei Leistungsbereiche von Mikroskopen unterscheiden. Zwischen etwa $10^6$ - $10^3$ nm ($10^7$ Å - $10^4$ Å) lateral und $10^5$ - 1 nm ($10^6$ A - 10 Å) vertikal liegen die verschiedenen Arten von Lichtmikroskopen 24 bis 28. Am ungünstigsten sind die einfachen Lichtmikroskope 24 mit einer numerischen Apertur von etwa 0,1. Leistungsfähigere Lichtmikroskope 25 mit einer numerischen Apertur von 1,4 haben eine günstigere laterale Auflösung. Die bessere vertikale Auflösung haben Geräte wie optische Interferometer 26, Differentialinterferenzmikroskope 27 oder Phasenkontrastmikroskope 28. Zwischen etwa $10^4$ - 1 nm ($10^5$ Å - 10 Å) lateral und $10^5$ - 10 nm ($10^6$ Å - $10^2$ Å) vertikal liegen Elektronenmikroskope. Das Elektronenmikroskop 29 überstreicht den bisher grössten Bereich der lateralen Auflösung. Das Raster-Elektronenmikroskop 30 ist in der vertikalen Auflösung besser. Praktisch den ganzen Bereich $10^7$ - 10 nm ($10^8$ Å - $10^2$ Å) lateral und $10^6$ - $10^{-2}$ nm ($10^7$ Å - $10^{-1}$ Å) vertikal überstreicht das erfindungsgemässe Raster-Tunnelmikroskop 31. Zu beachten ist insbesondere die bisher noch von keinem Gerät erreichte vertikale Auflösung.

Piezoelektrische Verstellvorrichtungen lassen sich gut aus Scheiben von Piezokeramik herstellen. Solche Scheiben tragen auf beiden Seiten metallische Überzüge für die Bildung von Elektroden. Die Scheibe ist so geschnitten, dass ein angelegtes positives elektrisches Feld eine Verlängerung in Richtung der Dickenausdehnung und eine Verkürzung in allen übrigen Richtungen bewirkt. Entsprechend dem Verwendungszweck kann man die Metallschicht mindestens einer Seite in einzelne Elektroden aufteilen. Die Metallschicht der anderen Seite kann man zweckmässig als gemeinsame Grundelektrode unzerteilt lasen. Mit Schleifkontakten kann man die Verstellströme den Elektroden zuführen. Die Fig. 10 zeigt ein Beispiel einer lateralen Verstellvorrichtung. Aus der Keramikscheibe ist ein L-förmiges Stück 32 mit aufeinander senkrecht stehenden Schenkeln herausgeschnitten. Auf der Oberseite bringt man zwei Elektroden 33, 34 an, bzw. man teilt die ursprüngliche Metallschicht so auf. An einem Ende 35 wird die Vorrichtung fixiert. Der ersten Elektrode 33 zugeführte Stellströme bewirken eine proportionale Verlängerung oder Verkürzung des einen Schenkels in der x-Richtung. Dadurch erfolgt auch eine Verstellung des anderen Schenkels parallel zu sich selbst. Der anderen Elektrode 34 zugeführte Stellströme bewirken eine proportionale Verlängerung oder Verkürzung des anderen Schenkels in der y-Richtung. Mit diesen beiden zusammengebauten lateralen Verstellvorrichtungen kann das freie Ende 36 des anderen Schenkels jeden beliebigen Flächenpunkt nach seinen x- und y-Koordinaten ansteuern. Man kann beispielsweise mittels des freien Endes 36 die daran befestigte Probe 4 lateral so positionieren, dass für die Untersuchung die Spitze 5 für die Abtastung durch eine ortsfest angebrachte z-Verstellvorrichtung zugeführt werden kann. Die Höhen-Verstellvorrichtung ist dann nur in der z-Achsenrichtung verstellbar. Man kann aber auch am freien Ende 36 eine in der z-Richtung wirkende Verstellvorrichtung anbringen. In diesem Falle ist die Probe 4 ortsfest angeordnet und die Vorrichtung nach der Fig. 10 verstellt die Abtastspitze 5 in allen drei Koordinatenrichtungen.

Die Fig. 11 und 12 zeigen eine bewährte Verstellvorrichtung für die z-Richtung. Diese kann einmal relativ grob im Bereich von einigen Millimetern verstellt werden. Das ist notwendig, um die Apparatur zu Beginn einer Untersuchung mit einer Probe beschicken zu können. Zum anderen kann die Höhen-Verstellvorrichtung auch sehr fein verstellt werden, was für die eigentliche Abtastung der Probenoberfläche notwendig ist. In einem trogartigen Führungsstück 37 kann ein speziell geformtes Stück 38 Piezokeramik sich in der z-Richtung in der Art eines Wurmes fortbewegen. Die Kanten 39 des Führungsstückes 37 sind sehr genau parallel eingeschliffen. Das Führungsstück 37 ist mit Hilfe einer Längsnut 40 federnd ausgebildet. So können bei jeder Temperatur, selbst in flüssigem Helium, die beiden Kanten 39 immer federnd und parallel an den Beinen des Formstücks 38 aus Piezokeramik anliegen. Das Formstück 38 ist im Grundriss im wesentlichen H-förmig. Zwei Paar Beine sind in Nuten in den Kanten 39 des Führungsstückes 37 geführt. Der Körper des Formstückes 38 entspricht dem Querbalken des H und bewegt sich in der Mitte des Führungsstückes 37 in Längsrichtung. In Verlängerung des Querbalkens des H erstreckt sich ein Kopfstück 41, das die Abtastspitze 5 trägt und für die Feineinstellung in z-Richtung dient.

Die Unterseite des Formstückes 38 trägt eine durchgehende Metallisierung als Grundelektrode. Treibelektroden 42, 43 und 44 bedecken entsprechende Teile des Formstückes 38 und dienen zusammen mit 4-phasigen Treibströmen für die wurmartige Fortbewegung. Die Hinterbeine tragen die Treibelektrode 42, der Körper ist mit der Treibelektrode 43 bedeckt und die Vorderbeine tragen die Treibelektrode 44. Das Kopfstück 41 trägt eine Verstellelektrode 45. Am vorderen Ende ist die Abtastspitze 5 angebracht. Die in der Zeichnung entsprechend den zugehörigen Elektroden bezeichneten Treibsignalzüge haben Impulse von etwa 1000 V mit einer Wiederholungsfrequenz von 100 Hz. Die an die Treibelektroden 42 und 44 der Beinpaare angelegten Treibsignale sind gegenphasig und bewirken wechselweises Verkürzen und damit Lockern eines Beinpaares in den Führungsnuten. Das der Treibelektrode 43 des Körpers zugeführte Treibsignal bewirkt abwechselnde Kontraktion und Elongation des Körpers und überlappt entweder die Vorderflanke oder die Rückflanke der Treibimpulsfolge eines Beinpaares. Je nach der Phasenbeziehung der Treibsignalfolge 43 erfolgt eine wurmartige Fortbewegung der Verstellvorrichtung in z-Richtung in dem einen oder dem anderen Richtungssinn.

Ist die Grobeinstellung in Einzelschritten von 1-3 nm (10 Å bis 30 Å) über einen Verstellweg in der Grössenordnung von Millimetern beendet, werden die Treibsignale 42, 43 und 44 abgeschaltet. Alle Beine des Formstückes 38 verklemmen sich fest in der Führungsnut. Die Feineinstellung erfolgt dann mit analogen Verstellströmen, die der Verstellelektrode 45 zugeführt werden. Das trogartige Führungsstück 37 ist aus Edelstahl gefertigt. Die beiden Kanten 39 können aus keramischem Material hergestellt sein. Wie aus der perspektivischen Übersicht der Fig. 12 ersichtlich ist, können die Kanten 39 mittels Schrauben mit dem Führungsstück 37 verbunden sein.

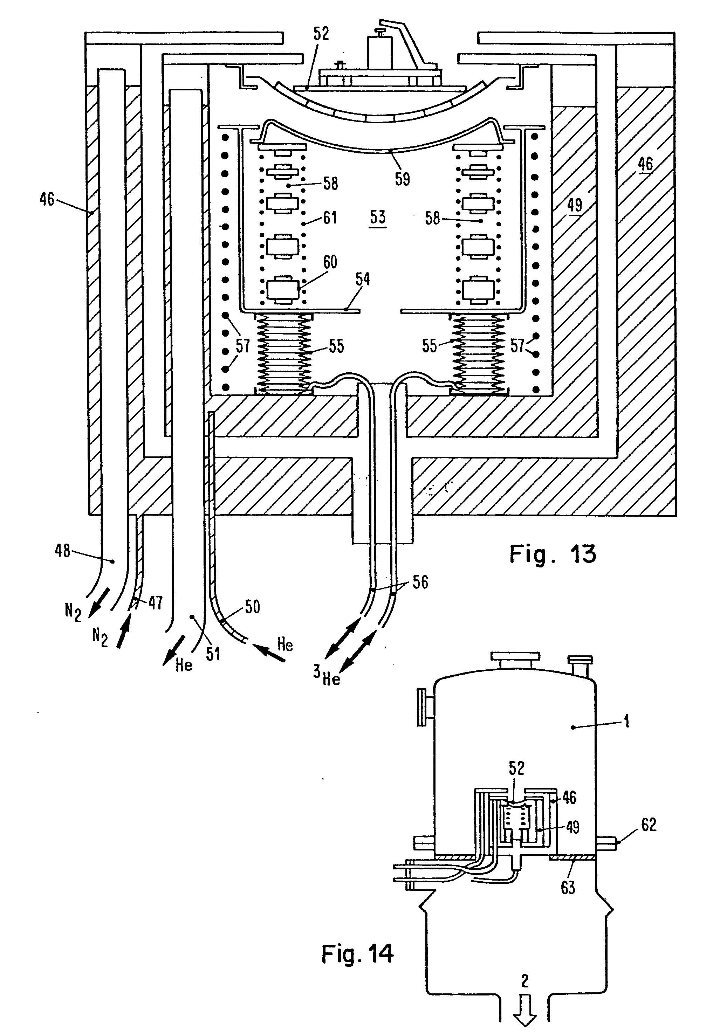

In der Ultra-Hochvakuumkammer sind die inneren Teile der Apparatur gut gekühlt und gut gelagert angeordnet. Eine schematische Übersicht gibt die Fig. 13. Beispielsweise kann man einen äusseren Kühlmantel 46 vorsehen, der über eine Einlassleitung 47 bis zu einem oberen Niveau mit flüssigem Stickstoff gefüllt werden kann. Eine Auslassleitung 48 mit grösseren Querschnitt dient zum Abzug von gasförmigem Stickstoff. Es können noch zusätzliche Einrichtungen für den Betrieb und die Regelung dieses ersten Kryostaten vorgesehen sein, die in der schematischen Zeichnung nicht dargestellt sind. Ein innerer Kühlmantel 49 enthält flüssiges Helium. Zweckmässig ist dieses Kühlgefäss als Mischkryostat ausgebildet der mit den Heliumisotopen $^3$He und Helium $^4$He arbeitet. Auch hier sind in der schematischen Zeichnung Einzelteile für den Betrieb und die Regelung des zweiten Kryostaten weggelassen. Es ist nur eine dünne Einlassleitung 50 und eine stärkere Auslassleitung 51 für Helium eingezeichnet. Die zu untersuchende Probe, die Abtastspitze mit ihren Verstellvorrichtungen und die Eingangsstufen für elektronische Geräte zur Auswertung, wie beispielsweise Messverstärker, sind in dem oberen Teil der Zeichnung in der Mitte auf einer besonderen Lagerung angeordnet, die im folgenden Schwebeschlitten genannt wird. Diese gesamte Anordnung ist in der Zeichnung mit 52 bezeichnet.

Es müssen zwei, sich in gewissem Sinne widersprechende Voraussetzungen für den Betrieb der Apparatur erfüllbar sein. Zum ersten muss für die ausserordentlich starke Kühlung die Wärme der inneren Teile gut abzuführen sein. Das geht nur durch Wärmeleitung, also durch eine dichte Packung der einzelnen metallischen Teile. Zum zweiten muss die auf dem Schwebeschlitten vorhandene Anordnung 52 völlig schwingungsfrei gelagert sein. Das verbietet eine dichte Packung mechanischer Teile. Ein möglicher Lösungsweg ist in der Zeichnung skizziert.

Ein Fahrmechanismus 53 dient beiden Zwecken. Im Innern des Kühlmantels 49 befindet sich ein Topf 54, der mittels freier Metallbalgen 55 in der Höhe verstellbar und im Niveau justierbar ist. Zum Aufwärtsfahren werden die Metallbalgen 55 mit einem Gas gefüllt, das bei der Arbeitstemperatur unter 1 K noch gasförmig ist und einen ausreichenden Druck annehmen kann. Als brauchbar hat sich das Heliumisotop $^3$He erwiesen. Leitungen 56 für das Helium sind mit den Metallbalgen 55 verbunden. Sie führen zu nicht dargestellten Einrichtungen für die Niveauregelung. Eine grosse Schraubenfeder 57 ist zwischen dem Topf 54 und dem inneren Kühlmantel 49 angeordnet. Da die Apparatur sich im Vakuum befindet, fehlt der äussere Luftdruck, der eine Rückstellung der Metallbalgen 55 ermöglichen würde, wenn ihre Gasfüllung reduziert wird. Für das Abwärtsfahren bringt die Schraubenfeder 57 eine entsprechende Rückstellkraft auf.

Im Topf 54 befinden sich Säulen 58 aus hintereinander geschalteten Schwingungsgliedern unterschiedlicher Eigenfrequenz, die eine kalottenförmige supraleitende Schale 59 aus Niobium tragen. Die Eigenfrequenzen der Schwingungsglieder sind gegeneinander verstimmt und sie sind so gewählt, dass keine störenden Schallimpulse, beispielsweise von einer laufenden Turbopumpe, auf die inneren Teile der Apparatur übertragen werden. Die unterschiedlichen Massen der Schwingungsglieder sind gut wärmeleitende Metallblöcke 60, beispielsweise aus Kupfer. Sie tragen Füsse, die auf entsprechende Füsse des benachbarten Metallblocks 60 passen, um wärmeleitenden Kontakt herzustellen, wenn sie durch entsprechende Betätigung des Fahrmechanismus 53 in Kontakt miteinander gebracht werden. Das ist notwendig zur Abfuhr der Wärme, wenn die Apparatur abgekühlt wird. Jede Säule 58 enthält Schraubenfedern 61, welche die einzelnen Schwingungsglieder mit den Metallblöcken 60 jeweils mit dem benachbarten Schwingungsglied verbinden. Die Enden der Säulen 58 sind oben und unten akustisch fehlangepasst. Sie sind beispielsweise in Glaswatte gelagert, um eine Übertragung von Schallimpulsen zu verringern.

Der Schwebeschlitten der Anordnung 52 besitzt eine Unterfläche, die in der Form der kalottenförmigen supraleitfähigen Schale 59 angepasst ist. Diese Unterfläche enthält eine grosse Anzahl von Permanentmagneten. Wenn bei entsprechend niedriger Temperatur die Schale 59 supraleitend geworden ist, kann die Anordnung 52 in geringem Abstand darüber schweben. Jede virtuelle Bewegung des Schwebeschlittens verursacht im Supraleiter starke Ströme, die ein magnetisches Gegenfeld aufbauen. Die Anordnung bleibt deshalb in der Schwebe. Wegen der Kalottenform ist die Gleichgewichtslage stabil. Über den Zwischenraum im Vakuum können keine störenden Schallimpulse übertragen werden.

Der Fahrmechanismus 53 ermöglicht beide oben erwähnten Voraussetzungen für den Betrieb der Apparatur. Zum Abkühlen können die Metallblöcke 60 der Säulen 58 in wärmeleitenden Kontakt gebracht werden, damit die Wärme aus den Teilen abgeleitet werden kann. Für den Betrieb des Raster-Tunnelmikroskops können die Säulen 58 gestreckt werden und dadurch die supraleitende Schale 59 so weit nach oben gebracht werden, dass ein einwandfreies Schweben des Schwebeschlittens mit der Anordnung 52 möglich ist. In den Endlagen sind die Bewegungsmöglichkeiten des Fahrmechanismus 53 durch Anschläge begrenzt. Auch die Anordnung 52 wird durch Anschläge vor dem Herunterfallen bewahrt, solange sich der Fahrmechanismus 53 in tiefen Lagen befindet oder die Schale 59 noch nicht supraleitend geworden ist.

Die Fig. 14 ist eine Übersichtszeichnung, teils im Schnitt, der Ultra-Hochvakuumkammer. Gleiche Bezugszeichen haben die gleiche Bedeutung wie in anderen Figuren. Die Ultra-Hochvakuumkammer 1 ist ein zylindrisches Stahlgefäss. An einem mittleren Flansch 62 kann das glockenartige Oberteil abgenommen werden. Im Unterteil sind auf einer Ringtraverse 63 nahe dem oberen Rand die inneren Teile der Apparatur montiert. Das Oberteil ist praktisch eine Vakuumglocke mit Beobachtungsfenstern und verschliessbaren Anschlussstutzen. Das Unterteil ist fest montiert. Es enthält einen Teil der nicht dargestellten Versorgungsgeräte, sowie zahlreiche Durchführungen für Versorgungsleitungen und nach unten die Verbindung zu den nicht dargestellten Pumpenaggregaten 2. Im Oberteil der Ultra-Hochvakuumkammer 1 ist noch genügend Platz, um in Ergänzung zu dem erfindungsgemässen Raster-Tunnelmikroskop gegebenenfalls noch andere Oberflächenuntersuchungsgeräte unterbringen zu können für die gleichzeitige Untersuchung der gleichen Probe nach anderen Prinzipien. Solche Geräte, die ebenfalls Ultra-Hochvakuum und tiefe Temperaturen benötigen, können beispielsweise Spektroskope sein, welche die Streuung oder die Beugung von Elektronen-, Röntgen- oder Korpuskularstrahlen an der gleichen Probe beobachten und auswerten.

**Patentansprüche**

1. Oberflächenuntersuchungsgerät höchster Auflösung, das den Vakuum-Tunneleffekt ausnutzt, mit einer Ultra-Hochvakuumkammer, die auf tiefe Temperaturen in der Nähe des absoluten Nullpunktes abgekühlt werden kann, in welcher Kammer eine leitende Probe als Basis-Elektrode vorgesehen ist, die mit einer feinen leitenden Spitze als Abtastelektrode zusammenarbeitet, die in einer Distanz über der Basis-Elektrode gehalten wird, bei der Tunnelströme fliessen können, dadurch gekennzeichnet, dass drei piezoelektrische Verstellvorrichtungen (6, 7, 8) vorgesehen sind, die in drei verschiedenen Dimensionen wirken, um die Spitze (5) und die Probe (4) relativ zueinander in solcher Weise zu verstellen, dass die Spitze als Raster-Abtastelektrode arbeitet, die über die Probenoberfläche geführt wird, dass ferner Messeinrichtungen (9) für den Tunnelstrom und für die Tunnelspannung, aus denen der Tunnelwiderstand ableitbar ist, vorhanden sind sowie eine elektronische Regeleinrichtung (10) für die Feineinstellung der piezoelektrischen Höhen-Verstellvorrichtung (8) in der z-Dimension, womit einer der genannten ermittelten Parameter durch Variation der Höheneinstellung der Abtastspitze kontant gehalten wird, und dass zusätzlich Auswerteeinrichtungen (11) vorhanden sind, um aus den Spitzenpositionswerten in allen drei Dimensionen bzw. aus ihren elektrischen Äquivalenten Information über die untersuchte Probenoberfläche abzuleiten und diese graphisch mit einem Zeichengerät (12) oder auf einem Bildschirm (13) aufzuzeichnen, das Ganze derart, dass der variierende Stellstrom der piezoelektrischen Höhen-Verstellvorrichtung (z) automatisch ein Abbild der wechselnden Oberflächeneigenschaften während der Abtastung einer Rasterlinie in einer lateralen Dimension (x) ergibt, während die andere laterale Dimension (y) konstant gehalten wird.

2. Gerät nach Anspruch 1, dadurch gekennzeichnet, dass die Höhen-Verstellvorrichtung (8) dazu eingerichtet ist, an jedem Messpunkt der Spitze (5) um den Mittelpunkt der Regelung (20) eine zusätzliche Abstandsmodulation um eine vorgegebene Schwankungsbreite (22) mit vorgegebener Frequenz auszuführen, und dass in den Auswerteeinrichtungen (11) ein phasen- und frequenzselektiver Mitziehverstärker vorhanden ist, um die örtliche Änderung der Austrittsarbeit zu erfassen.

3. Gerät nach Anspruch 1, dadurch gekennzeichnet, dass die piezoelektrischen Verstellvorrichtungen (6, 7, 8) mit metallischen Elektroden belegte Formstücke aus Piezo-Keramik enthalten.

4. Gerät nach Anspruch 3, dadurch gekennzeichnet, dass die piezoelektrische Verstellvorrichtung (6, 7) für die lateralen Dimensionen (x, y) ein L-förmiges Formstück (32) aus Piezo-Keramik mit Elektroden (33, 34) auf jedem der Schenkel aufweist, dass ein Ende (35) der Vorrichtung fixiert ist und dass das freie Ende (36) durch eine den Verstellströmen proportionale Verlängerung oder Verkürzung der Schenkel auf einen beliebigen Koordinatenpunkt (x, y) in einer Ebene verstellbar ist.

5. Gerät nach Anspruch 3, dadurch gekennzeichnet, dass die piezoelektrische Verstellvorrichtung (8) für die Höhen-Dimension (z) ein mit Elektroden (42 bis 45) belegtes, im wesentlichen H-förmiges, aus zwei parallelen Schenkeln, dem diese Schenkel verbindenden Querbalken und einem in dessen Verlängerung angeordneten Kopfstück (41) bestehendes Formstück (38) aufweist, wobei jeder Schenkel, der Querbalken und das Kopfstück mit je einer Elektrode (42 und 44; 43; 45) bedeckt ist, dass die Enden der Schenkel in Nuten von parallelen Kanten (39) eines trogartigen Führungsstückes (37) geführt sind, und dass das Kopfstück (41) die Abtastspitze (5) trägt, das Ganze derart, dass durch den Elektroden der Schenkel (42, 44) und des Querbalkens (43) zugeführte 4-phasige Treibströme eine wurmartige Fortbewegung für die Grobeinstellung erzielbar ist durch wechselweises Verkürzen (Lockern) und Verlängern (Festklemmen) der Schenkel, sowie durch abwechselndes Verlängern und Verkürzen des Querbalkens, und dass die Feineinstellung bei allseits verklemmten Schenkeln mittels Verstellung des Kopfstückes erfolgt.

6. Gerät nach Anspruch 1, dadurch gekennzeichnet, dass innerhalb der Ultra-Hochvakuumkammer (1) ein äusserer Kühlmantel (46) für flüssigen Stickstoff einen inneren Kühlmantel (49) für flüssiges Helium umschliesst, in dessen Innenraum sich ein in vertikaler Richtung betätigbarer Fahrmechanismus (53) befindet, der, auf einem Schwebeschlitten (52) gelagert, die wesentlichen Teile der Apparatur mit der Probe (4) und der Abtastspitze (5) sowie ihren Verstellvorrichtungen (6, 7, 8) trägt.

7. Gerät nach Anspruch 6, dadurch gekennzeichnet, dass der Fahrmechanismus (53) einen Topf (54) aufweist, der auf mit gasförmigem $^3$He füllbaren Metallbalgen (55) ruht, dass ausserhalb des Topfes eine Schraubenfeder (57) zum Aufbringen einer Gegenkraft vorgesehen ist, dass innerhalb des Topfes eine supraleitfähige Schale (59) auf Säulen (58) aus Federelementen mit Metallblöcken (60) und mit Schraubenfedern (61) ruhend angeordnet ist, und dass der Schwebeschlitten (52) eine Unterseite besitzt, deren Form der Schale (59) angepasst ist und eine Anzahl von Permanentmagneten trägt.

**Claims**

1. Apparatus for highest resolution surface analysis using the vacuum tunnel effect, with an ultra-high vacuum chamber, which can be cooled down to a temperature close to absolute zero, in which chamber there is provided a conducting sample as base electrode which cooperates with a fine conducting tip serving as scanning electrode, the latter being positioned above the sample at a distance at which tunneling currents can flow, characterized in that there are provided three piezo electrical drive means (6, 7, 8) acting in three different dimensions to adjust the tip (5) and the sample (4) relative to each other in such a way that the tip is operating as a scanning electrode which is directed across the sample surface, that there are further provided measuring equipment (9) for the tunneling current and for the tunneling voltage to derive therefrom the tunnel resistance, an electronic automatic control means (10) for fine adjustment of the piezo electric drive means for the vertical dimension (z), whereby one of the electrical parameters is being kept constant by varying the vertical adjustment of the scanning tip, and that there are provided additional analyzing means (11), to provide information about the sample surface structure derived from the three-dimensional tip coordinates or from their electrical equivalents, respectively, and to record these graphically with a plotter (12) or on a viewing screen (13), the apparatus operating such, that the varying drive current of the piezo electric vertical dimension (z) drive means provides an image of the varying surface properties during scanning of a raster line in one lateral dimension (x), while the other lateral dimension (y) is being kept constant.

2. Apparatus according to claim 1, characterized in that the vertical drive means (8) is designed to provide, at every measuring point of the tip (5) an additional distance modulation, with predetermined amplitude and frequency, about the center point of the automatic control (20), and that the analyzing means (11) comprise a phase and frequency selective lock-in amplifier in order do detect local changes of the work function.

3. Apparatus according to claim 1, characterized in that the piezo electrical drive means (6, 7, 8) comprise shaped pieces of piezo ceramic covered with metallic electrodes.

4. Apparatus according to claim 3, characterized in that the piezo electric drive means (6, 7) for the lateral dimension (x, y) comprises a L-shaped piece (32) of piezo ceramic with electrodes (33, 34) at each of its legs, that one end (35) of the device is fixed and that the free end (36) can be moved to any coordinate point (x, y) by an elongation or a contraction of the legs proportional to the drive currents applied.

5. Apparatus according to claim 3, characterized in that the piezo electric vertical drive means (8) for the z dimension comprises a piece of piezo ceramic which is covered by electrodes (42 to 45) end essentially H-shaped, having hind legs, fore legs, and a connecting body with a laterally extending head (41), wherein one electrode each covers the pair of hind legs (42), the body (43), the pair of fore legs (44) and the head (45), that the legs are guided in notches of parallel edges (39) of a trough-shaped guide member (37), and that the head (41) carries the scanning tip (5), the drive means operating such that a worm-like movement can be achieved for the coarse adjustment by 4-phase drive currents applied to the electrodes of the pairs of legs (42, 44) and the body (43) which cause alternate contraction (loosening) and elongation (clamping) of the pairs of legs, as well as by alternating elongation and contraction of the body, and that the fine adjustment occurs by controlling the head when all pairs of legs are clamped.

6. Apparatus according to claim 1, characterized in that there is provided within the ultra-high vacuum chamber (1) an outer cooling jacket (46) for liquid nitrogen which encloses an inner cooling jacket (49) for liquid helium, the interior of which encloses a drive mechanism (53) movable in vertical direction, the mechanism, arranged on a hovering support (52), carrying the essential parts of the assembly comprising the sample (4) and the scanning tip (5) as well as their drive means (6, 7, 8).

7. Apparatus according to claim 6, characterized in that the drive mechanism (53) comprises a pot (54) supported by metal bellows (55) filled with $^3$He, that there is provided a helical spring (57) outside the pot to provide a return force, that within the pot there is provided a superconductive tray (59) supported by columns (58) with metal blocks (60) and spiral springs (61), and that the shape of the bottomside of the hovering support (52) matches the form of the tray (59) carries a number of permanent magnets.

## Revendications

1. Appareil à balayage à très haute résolution pour l'analyse de surfaces par effet tunnel sous vide comportant une enceinte à ultra vide refroidie à des températures basses avoisinant le zéro absolu, dans laquelle on place un échantillon conducteur agissant comme électrode de base qui coopère avec une pointe conductrice fine agissant comme électrode de balayage et qui est maintenue par rapport à l'électrode de base à une distance correspondant au tunnel d'écoulement des courants, caractérisé en ce qu'il est prévu trois appareils piézo-électriques (6, 7, 8) permettant un réglage sur trois dimensions afin de déplacer ladite pointe (5) et ledit échantillon (4) l'une par rapport à l'autre de telle sorte que ladite pointe agisse comme électrode de balayage de champ au-dessus de ladite surface de l'échantillon, qu'il est prévu des dispositifs de mesure (9) du courant et de la tension dans le tunnel à partir desquelles la résistance dans le tunnel peut être déduite, et d'une dispositif de commande électronique (10) permettant le réglage fin dudit dispositif (8) piézo-électrique destiné au déplacement vertical (dimension z), où un desdits paramètres détectables est maintenu constant en modifiant le réglage vertical de ladite pointe de balayage, qu'il est prévu des dispositifs d'analyse supplémentaires (11) permettant de déduire à partir des valeurs de positionnement de ladite pointe dans les trois dimensions ou de leurs équivalents électriques des informations concernant la surface de l'échantillon balayée et d'enregistrer graphiquement ces dernières soit sur une table traçante (12) soit sur un écran (13), l'ensemble de l'appareil permettant la représentation automatique des différentes propriétés de ladite surface au cours du balayage dans une dimension latérale (x) d'une ligne du champ au moyen de la modulation du courant de commande dudit dispositif piézo-électrique destiné au réglage vertical (z) tandis que l'autre dimension est maintenue constante.

2. Appareil selon la revendication 1, caractérisé en ce que le dispositif de réglage vertical (8) est conçu de sorte que la distance varie, pour chaque point de mesure de ladite pointe (5), dans une plage (18) donnée avec une fréquence donnée, et qu'il est prévu dans les dispositifs d'analyse (11) un amplificateur à phase et à fréquence sélectivement bloqués pour enregistrer la variation locale du travail de sortie.

3. Appareil selon la revendication 1, caractérisé en ce que les dispositifs de déplacement piézo-électriques (6, 7, 8) comportent des pièces façonnées en piézo-céramique recouvertes d'électrodes métalliques.

4. Appareil selon la revendication 3, caractérisé en ce que ledit dispositif piézo-électrique (6, 7) de réglage dans les dimensions latérales (x, y) comprend une pièce (32) en piézo-céramique façonnée en forme de L qui comporte des électrodes (33, 34) sur chacun de ses deux bras, qu'une extrémité (35) dudit dispositif est fixé alors que son autre extrémité (36) est libre et peut être déplacée selon un plan un point de coordonnés (x, y) quelconque au moyen d'un allongement ou d'un raccourcissement desdits bras proportionnels auxdits courants de commande.

5. Appareil selon la revendication 3, caractérisé en ce que, ledit dispositif piézo-électrique (8) pour le réglage dans la dimension verticale (z) comporte une pièce (38) façonné × e en forme de H, constituée de deux bras parallèles, d'une traverse reliant les deux bras et d'une pièce de tête (41) montée dans le prolongement de la traverse, et qui comporte des électrodes (42 à 45) recouvrant respectivement chacun desdits bras (42 et 44), ladite traverse (43), et ladite pièce de tête (45), que les extrémités desdits bras son guidées dans des rainures agencées dans les bords parallèles (39) d'une pièce de guidage (37) en forme d'auge, que la pièce de tête (41) supporte ladite pointe de balayage (5), que l'ensemble de l'appareil est tel que les courants moteurs à quatre phases s'écoulant à travers les électrodes desdits bras (42, 44) et de ladite traverse (43) aboutissent à un réglage grossier exécuté selon un mouvement vermiculaire et obtenu par, tout à tour, un raccourcissement (relachement) et un allongement (resserrement) desdits bras, et par l'allongement et le raccourcissement alternatifs de ladite traverse, et que le réglage fin résulte du bloquage desdits bras en déplaçant ladite pièce de tête.

6. Appareil selon la revendication 1, caractérisé en ce que, à l'intérieur de ladite enceinte à ultra vide, une enveloppe réfrigérante externe (46) destinée à l'azote fluidifié entoure une envelope réfrigérante interne (49) destinée à l'hélium fluidifié dans laquelle est disposé un mécanisme (53) pouvant être déplacé de façon verticale et monté sur un support suspendu (52), afin de supporter les élément s principaux dudit appareil avec l'échantillon (4) et la pointe de balayage (5) ainsi que les dispositifs de réglage (6, 7, 8) leurs correspondant.

7. Appareil selon la revendication 6, caractérisé en ce que ledit mécanisme (53) comporte un couvercle (54) qui repose sur un soufflet métallique (55) pouvant être rempli avec du He gazeux, qu'il est prévu en plus dudit couvercle un ressort hélicoidal (57) destiné à exercer une force de rappel, qu'il est prévu à l'intérieur dudit couvercle un plateau-cuvette (59) supraconducteur supporté par des colonnes (58) constituées d'éléments à ressort comportant des blocs métalliques (60) et des ressorts hélicoidaux (61), et que ledit support suspendu comporte une base dont la forme est adaptée audit plateau-cuvette (59) et qui supporte une pluralité d'aimants permanents.

Fig. 1

Fig. 2

$$I \sim e^{-a\sqrt{\Phi} \cdot d}$$

Fig. 3

Fig. 4

Fig. 5

Fig. 6

13

# Fig. 7

$$\frac{dI}{dz} \sim \sqrt{\Phi}$$

# Fig. 8

$$\left(\frac{dI}{dz}\right)^2 \sim \Phi$$

$V_x \ (V_y) \longrightarrow$

# Fig. 9

# Fig. 10

# Fig. 12

# Fig. 11

Fig. 13

Fig. 14